Europäisches Patentamt

European Patent Office

Office européen des brevets

(11) Veröffentlichungsnummer: **0 101 999**
**A1**

(12) # EUROPÄISCHE PATENTANMELDUNG

(21) Anmeldenummer: 83107873.8

(22) Anmeldetag: 09.08.83

(51) Int. Cl.³: **H 01 L 41/08**

(30) Priorität: 20.08.82 DE 3231117

(43) Veröffentlichungstag der Anmeldung:
07.03.84 Patentblatt 84/10

(84) Benannte Vertragsstaaten:
AT BE CH DE FR GB IT LI LU NL SE

(71) Anmelder: SIEMENS AKTIENGESELLSCHAFT
Berlin und München Wittelsbacherplatz 2
D-8000 München 2(DE)

(72) Erfinder: van der Linden, Klaus
Innerer Ring 40
D-8640 Kronach(DE)

(72) Erfinder: Drews, Wolf-Dietrich, Dr.
Pommernstrasse 8
D-8620 Lichtenfels(DE)

(54) Piezoelektrischer Koppler, insbesondere elektromechanischer Zündkoppler.

(57) Die Erfindung betrifft einen piezoelektrischen Koppler mit Primär- und Sekundärelektrode und einer Umhüllung. Der Piezokoppler besteht aus mehreren ganzflächig aktiv genutzten Piezokeramikfolien (1) and (2), die bis auf eine isolierende Randzone (12, 22) von maximal 1 mm beidseitig ganzflächig metallisiert sind (9). Die primäre Piezokeramik (1) und die sekundäre Piezokeramik (2) sind durch eine hochisolierende Kunststoffschicht (3), insbesondere eine oder mehrere Kunststoffolien getrennt. Die Schichten sind mit Kunststoff, einem Lack und/oder Prepreg und/oder einem Gehäuse, umhüllt. Der piezoelektrische Koppler findet vornehmlich als elektromechanischer Zündkoppler Verwendung.

FIG 2

EP 0 101 999 A1

Croydon Printing Company Ltd

SIEMENS AKTIENGESELLSCHAFT      Unser Zeichen
Berlin und München              VPA  82 P 3 2 5 6  E

Piezoelektrischer Koppler, insbesondere elektromechanischer Zündkoppler

Die Erfindung betrifft einen piezoelektrischen Koppler
mit Primär- und Sekundärelektrode und einer Umhüllung,
insbesondere für elektromechanische Zündkoppler.

Zum Zünden von Thyristoren mittels einer zum Thyristor
galvanisch entkoppelten Ansteuerelektronik wird vielfach für die Entkopplung ein optoelektronisches Koppelelement verwendet.

Aus DE-OS 30 15 301 (VPA 80 P 7046) ist ein Piezokoppler bekannt, bestehend aus einem weniger als 0,3 mm
dicken Plättchen aus piezokeramischem Material, auf
dessen einer Oberfläche wenigstens zwei Elektroden und
auf dessen gegenüberliegender Oberfläche wenigstens
zwei weitere jeweils gleichgroße Gegenelektroden angeordnet sind, wobei jeweils eine Elektrode und ihre im
wesentlichen deckungsgleich gegenüberliegende Gegenelektrode ein Elektrodenpaar bilden, wobei ein Elektrodenpaar als Eingangselektrodenpaar mit der Steuerelektronik verbunden ist und eine Elektrode eines Ausgangselektrodenpaares mit der Zündelektrode eines
Thyristors oder eines Triacs verbunden ist, wobei die
Elektroden des Eingangselektrodenpaares einen für die
galvanische Entkopplung ausreichenden elektrischen
Isolationswiderstand von den Elektroden des Ausgangselektrodenpaares haben, und wobei mit der jeweiligen
Elektrode verbundene Anschluß-Zuleitungen an den Plättchen angebracht sind.

Td 2 Gr / 4.8.1982

Gemäß der DE-OS 30 35 503 (VPA 80 P 7138) hat das Plättchen eine Form mit einer mehr als zweizähligen Drehsymmetrieachse, und es kann eine an der Oberfläche des Plättchens bzw. an dessen Elektroden dicht anliegende Hülle vorgesehen sein, die auch die Anschlüsse der Anschlußzuleitungen an den Elektroden mit abdeckt. Die Umhüllung kann aus einem Kunstharzlack bestehen oder auch ein Epoxid-Glasfaservlies (Prepreg) sein.

Die hier eingesetzten Piezokörper haben für viele Anwendungszwecke eine zu große Bauform. Bei der Miniaturisierung der bekannten Piezoelemente nimmt - bedingt durch die Anordnung der Primär- und Sekundärelektrode auf einer einteiligen Keramikfolie - der effektive Wandlungsfaktor ·ab. Für die Spannungsfestigkeit des Bauteiles muß ein Mindestabstand zwischen Primär- und Sekundärelektrode gesichert sein, so daß der Anteil der piezoaktiven Fläche bei der Verkleinerung des Bauteils überproportional abnimmt.

Ferner sind bei den herkömmlichen Piezokopplern bei Vertauschung von Primär- und Sekundärkontakten die elektrischen Daten erheblich verändert. Vielfach ist keine Kombination mit genormten IC-Gehäusen möglich.

Der Erfindung liegt die Aufgabe zugrunde, diese Nachteile zu überwinden. Die Koppler sollen unter Beibehaltung des Kopplungsfaktors kleiner sein. Im Hinblick auf ihren Einsatz zur galvanischen Entkopplung, beispielsweise in Mikroprozessorsystemen, sollen sie mit möglichst niedriger Versorgungsspannung betrieben werden können. Die Herstellung von "Minikopplern" soll einfach realisierbar sein.

Diese Aufgabe wird mit einem Piezokoppler gelöst, der erfindungsgemäß gebildet ist aus mehreren ganzflächig aktiv genutzten Piezokeramikfolien, die bis zu einer isolierenden Randzone von maximal 1mm beidseitig ganzflächig metallisiert sind, und deren primäre Piezokeramikfolien und sekundäre Piezokeramikfolien durch eine hochisolierende Kunststoffschicht getrennt sind.

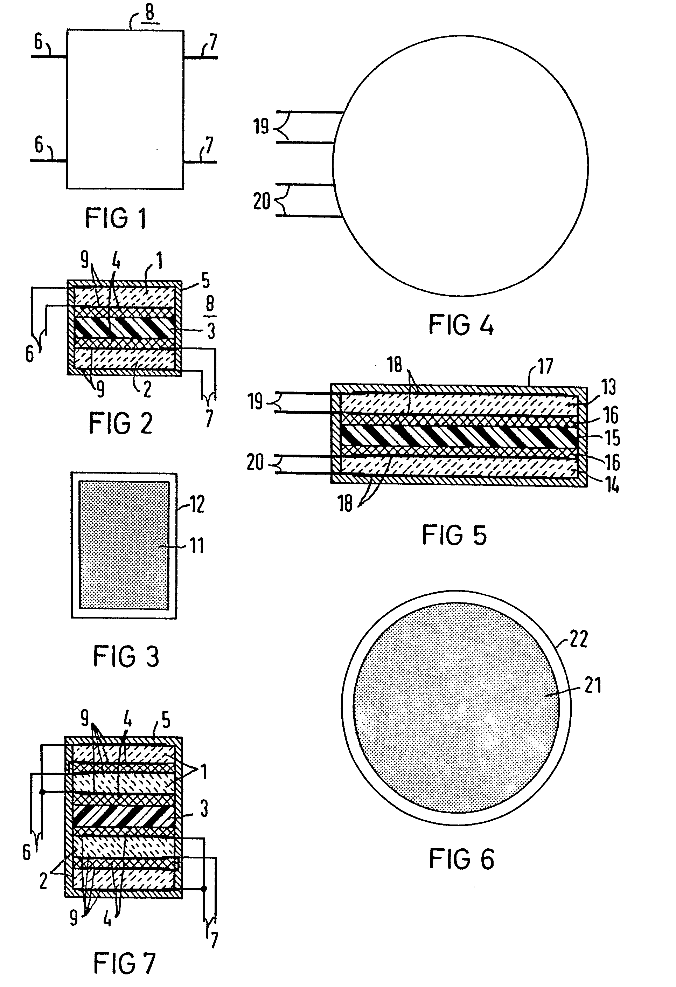

Es können auch mehrere Einzelelemente parallel geschaltet sein (FIG 7). Eine Ausführung gemäß der Erfindung mit mehreren parallelgeschalteten Einzelelementen, wobei die Einzelelemente der Primär- bzw. Sekundärseite jeweils getrennt parallel geschaltet sind, ist auch mit Potential-trennenden Kunststoffolien möglich (FIG 7). Hierdurch ist die Wahrscheinlichkeit eines Fehlers bei der Potentialtrennung erheblich geringer.

Gemäß der Erfindung sind Primär- und Sekundärseite des Kopplers beidseitig der isolierenden Kunststoffschicht angeordnet. Er besteht somit aus vollständig voneinander getrennten und ganzflächig metallisierten, mit Isolierrand versehenen Piezokeramiken (siehe FIG 1 und 2).

Der piezoelektrische Koppler kann in einer besonders vorteilhaften Ausführungsform aus zwei ganzflächig aktiv genutzten Piezokeramikfolien aufgebaut sein, die bis auf einen kleinen Rand metallisiert sind.

Der erfindungsgemäße Aufbau des piezoelektrischen Kopplers ist wesentlich kompakter. Die Eigenschaften dieser in kompakter Mehrschichttechnik hergestellten Piezokoppler bleiben über lange Zeiträume konstant.

Durch den erfindungsgemäßen Einsatz von hochisolierenden Kunststoff, insbesondere Kunststoffolien, können wesentlich höhere Potentialtrennungsspannungen erreicht werden. Die komplizierte Siebdruckstruktur wird durch eine einfacher zu prüfende, ganzflächige Metallisierungsschicht ersetzt (FIG 3). Es ist möglich, Primär- und Sekundärseite ohne eine Beeinträchtigung der elektrischen Funktion technisch gleichartig auszubilden, so daß eine Symmetrie zwischen Primär- und Sekundärseite vorhanden ist, was eine wesentlich einfachere Handhabung des Kopplers, ohne die Gefahr der Elektrodenverwechslung bedeutet. Der mechanische und elektrische Aufbau dieser Koppler ist außerordentlich einfach, so daß sie in großen Stückzahlen mit niedrigen Kosten hergestellt werden können. Der Koppler gemäß der Erfindung kann mit relativ hoher Energie betrieben werden. Die kompakte Bauweise gestattet die Herstellung von Zündkopplern für beispielsweise genormte IC-Gehäuse. Durch die kleineren Abmessungen lassen sich außerdem höhere Arbeitsfrequenzen erzielen.

Erfindungsgemäße piezoelektrische Koppler, die jede geometrische Form haben können, bei der sich der Piezokeramikverbund zu nutzbaren Schwingungen anregen läßt, können beispielsweise rechteckig, quadratisch, kreisrund oder oval sein.

Für die Erfindung eingesetzte Folien aus Piezokeramik können nach bekannten Verfahren vornehmlich nach dem Folien-Ziehverfahren hergestellt sein. Die Dicke der Keramikfolie beträgt 0,05 bis 1 mm.

Die Kunststoffschicht, die vorzugsweise als Folie vorliegt, kann eine Dicke von 5 µm bis 3 mm haben. Besonders bewährt haben sich Folien aus Polycarbonatkunststoffen (Makrolon ⓡ ) oder Polyäthylen (Hostalen ⓡ ).

Die Verklebung der einzelnen Schichten des Kopplers miteinander, kann durch ein Prepreg (mit Epoxidharz getränktes Glasfaservlies) oder durch Kleber auf verschiedenster Basis, beispielsweise Epoxidharzkleber erfolgen.

Das in kompakter Mehrschichttechnik hergestellte Bauteil kann mit Kunstharzlack und/oder einem dicht anliegenden Prepreg umhüllt sein. Die Dicke der Schutzschicht liegt bei ca. 5 µm. In manchen Fällen haben sich auch Gehäuse insbesondere aus Kunststoff bewährt, welche auch zusammen mit einer Schutzschicht aus Lack oder Prepreg eingesetzt werden können. Im Hinblick auf den industriellen Einsatz haben sich Dual-Inline-Gehäuse (IC-Gehäuse) besonders bewährt. In einigen Fällen sind auch durch Wirbelsintern aufgetragene Schutzschichten vorteilhaft.

Die erfindungsgemäßen piezoelektrischen Koppler eignen sich zur galvanischen Trennung in elektrischen Systemen. Sie finden insbesondere Verwendung als Piezozündkoppler zur Ansteuerung von elektronischen Leistungsschaltern.

Im folgenden wird die Erfindung anhand von schematischen Zeichnungen näher erläutert. Es zeigt

FIG 1 eine Draufsicht eines rechteckigen Kopplers gemäß der Erfindung,

FIG 2 zeigt den Koppler von FIG 1 im Schnitt,

FIG 3 in Draufsicht die Piezokeramik des Piezokörpers gemäß FIG 1,

FIG 4 eine Draufsicht eines kreisrunden Kopplers gemäß der Erfindung,

FIG 5 zeigt den Koppler von FIG 4 im Schnitt,

FIG 6 in Draufsicht die Piezokeramik des Piezokörpers gemäß FIG 4,

FIG 7 einen Koppler mit mehreren parallelgeschalteten rechteckigen Piezokeramiken im Schnitt.

In FIG 1 ist ein rechteckiger Koppler dargestellt. Die Primärelektroden 6 und die Sekundärelektroden 7 sind auf den gegenüberliegenden Seiten.

Der in FIG 2 gezeigte Koppler 8 ist mit den Primärelektroden 6 und den Sekundärelektroden 7 versehen, die fest auf den gegenüberliegenden Seiten der jeweiligen Piezokeramik aufgelötet sind. Die durch mindestens eine Kunststoffolie 3 aus Hostalen ® getrennte primäre Piezokeramik 1 und sekundäre Piezokeramik 2, die mit Silber 9 ca. 15 µm ganzflächig metallisiert sind, sind untereinander durch Klebeschichten 4 aus Prepreg verbunden. Das den gesamten Verbund umhüllende Prepreg ist
mit 5 bezeichnet.

In der FIG 3 ist in Draufsicht eine Piezokeramik des
Piezokörpers nach FIG 1 mit rechteckigem Querschnitt
dargestellt. Die Metallisierung ist mit 11 und die unmetallisierte Keramik mit 12 bezeichnet.

In FIG 4 ist ein kreisrunder Koppler dargestellt, der
mit den Primärelektroden 19 und den Sekundärelektroden 20
versehen ist.

In FIG 5 ist ein erfindungsgemäßer rechteckiger Koppler
mit der primären Piezokeramik 13 und der sekundären
Piezokeramik 14 dargestellt. Die Piezokeramikfolien 13,
14 sind mit Silber 18 ganzflächig in einer Stärke von
15 µm metallisiert. Zwischen den mit Silber beschichteten
Keramikfolien ist eine Kunststoffolie 15 eingebracht.
Die einzelnen Teile sind durch einen Kleber 16 auf Basis
von Epoxidharz verbunden. Die Umhüllung bildet ein
Kunstharzlack 17.

In der FIG 6 ist in Draufsicht eine Keramik des kreisrunden Kopplers gemäß FIG 4 gezeigt. Die Metallisierung
ist mit 21 und die unmetallisierte Keramik mit 22 bezeichnet.

FIG 7 zeigt mehrere Piezokeramiken in Parallelschaltung.
Es sind wiederum bezeichnet mit 1 die primären Keramiken, mit 2 die sekundären Piezokeramiken, mit 3 die
Kunststoffolien, mit 4 die Klebeschichten, mit 5 der
Schutzlack, mit 6 die primären Elektroden mit 7 die sekundären Elektroden und mit 9 die Silbermetallisierungen.

8 Patentansprüche
7 Figuren

Patentansprüche

1. Piezoelektrischer Koppler mit Primär- und Sekundärelektrode und einer Umhüllung, insbesondere für elektromechanische Zündkoppler, g e k e n n z e i c h n e t
d u r c h einen Piezokoppler aus mehreren ganzflächig
aktiv genutzten Piezokeramikfolien (1) und (2), die
bis auf eine isolierende Randzone (12, 22) von maximal
1 mm beidseitig, ganzflächig metallisiert sind und deren primäre Piezokeramikfolien (1) und sekundäre Piezokeramikfolien (2) durch eine hochisolierende Kunststoffschicht (3) getrennt sind.

2. Piezoelektrischer Koppler nach Anspruch 1, d a -
d u r c h g e k e n n z e i c h n e t , daß die aktiv
genutzten und metallisierten Piezokeramikfolien (1) und
(2), die durch die hochisolierende Kunststoffschicht (3)
getrennt sind, parallelgeschaltet sind.

3. Piezoelektrischer Koppler nach Anspruch 1 und 2,
d a d u r c h g e k e n n z e i c h n e t , daß zwei
ganzflächig aktiv genutzte und metallisierte Piezokeramikfolien (1, 2) durch eine Kunststoffschicht (3)
getrennt sind.

4. Piezoelektrischer Koppler nach Anspruch 1 bis 3,
d a d u r c h g e k e n n z e i c h n e t , daß die
Kunststoffschicht (3) aus einer oder mehreren Kunststofffolien besteht.

5. Piezoelektrischer Koppler nach Anspruch 4, d a -
d u r c h g e k e n n z e i c h n e t , daß die
Folie aus einen Polycarbonat-Kunststoff (Makrolon ®)
besteht.

0101999

VPA 82 P 3 2 5 6 E

6. Piezoelektrischer Koppler nach Anspruch 1 bis 5, d a d u r c h   g e k e n n z e i c h n e t , daß die Umhüllung (5) aus dichtanliegendem Prepreg, und/oder Kunstharzlack und/oder einem Gehäuse, besteht.

7. Piezoelektrischer Koppler nach Anspruch 6, d a - d u r c h   g e k e n n z e i c h n e t , daß das Gehäuse ein IC-Gehäuse ist.

8. Piezoelektrischer Koppler nach Anspruch 1 bis 7, d a d u r c h   g e k e n n z e i c h n e t , daß die Piezokeramikfolien rechteckige Form haben.

FIG 1

FIG 2

FIG 3

FIG 4

FIG 5

FIG 6

FIG 7

## Europäisches Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | CH-A- 486 789 (HONEYWELL)<br>* Spalte 1, Zeilen 1-11; Ansprüche * | 1-8 | H 01 L 41/08 |
| D,A | EP-A-0 038 496 (SIEMENS)<br>* Zusammenfassung * | 1 | |
| A | FR-A-2 136 142 (RCA) | | |

| | |
|---|---|
| | RECHERCHIERTE SACHGEBIETE (Int. Cl. ³) |
| | H 01 L 41 |

Der vorliegende Recherchenbericht wurde für alle Patentansprüche erstellt

| Recherchenort<br>DEN HAAG | Abschlußdatum der Recherche<br>11-10-1983 | Prüfer<br>PELSERS L. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82